# EUROPEAN PATENT SPECIFICATION

(11) **EP 1 358 499 B1**
(45) Date of publication and mention of the grant of the patent: **14.04.2010**
(21) Application number: 01270780.8
(22) Date of filing: 14.12.2001
(51) Int. Cl.: G01R 31/327

(54) **TAP CHANGER MONITORING**
ÜBERWACHUNG EINES LASTSTUFENSCHALTERS
SURVEILLANCE DE SELECTEUR DE CHARGE

(30) Priority: 15.12.2000 US 255424 P
(43) Date of publication of application: 05.11.2003
(73) Proprietor: ABB Technology AG, 8050 Zürich (CH)
(72) Inventor: STENESTAM, Bengt-Olof, S-771 42 Ludvika (SE); ANDERSSON, Gunnar, S-770 14 Nyhammar (SE)
(74) Representative: Dahlstrand, Björn
(86) International application number: PCT/SE2001/002782
(87) International publication number: WO 2002/048729

(56) References cited:
- WO-A1-00/44011
- WO-A1-93/23760
- US-A- 6 023 404
- PATENT ABSTRACTS OF JAPAN & JP 01 095 505 A (TOSHIBA CORP) 13 April 1989
- PATENT ABSTRACTS OF JAPAN & JP 02 213 105 A (HITACHI LTD) 24 August 1990
- PATENT ABSTRACTS OF JAPAN & JP 61 018 113 A (MITSUBISHI ELECTRIC CORP) 27 January 1986

## Description

### TECHNICAL FIELD

The present invention relates in general to tap changers and in particular to a method and apparatus for diagnosing the condition of a tap changer.

### BACKGROUND

High voltage and medium voltage transformers are widely used in electrical power distribution of today. Utilizing the magnetic features of electrical currents, they transfer power between two or more incompatible electrical AC-circuits. Thereby, power from a power plant can be transported by a small current of very high voltage and then stepped down to a large current of low voltage before reaching the users.

Supply authorities are under obligation to their customers to maintain the supply voltage between certain limits. A tap changer is a device used in a transformer for regulation of the transformer output voltage within these limits. Normally, this is achieved by changing the ratios of the transformers of the system by altering the number of turns in one winding of the appropriate transformer(s). A lower load on the system may for instance require that tap-changing operations decrease the number of turns in the winding. This ultimately results in an increased output voltage as compared to if no tap changing were performed. Normally, a tap changer performs in the range of 5-20 changing operations per day, but for very demanding systems, such as melting furnaces, there may be hundreds of such operations per day.

Besides the described application, tap changers may also be used in connection with other inductive power devices such as reactors. Tap changers are either on-load, i.e. operating while the transformer is energized, or off-load and there is a wide range of models available. A tap changer generally comprises a number of switches for tap changing and a number of resistors or other impedances to prevent short-circuiting. Furthermore, the tap changer typically is filled with an insulating liquid, such as oil, which besides insulation offers cooling of the device.

Problems during switching in tap changers are not usual, but can be very serious when they occur. Such problems are mostly related to a long switching time, in turn a result of e.g. wear or broken details. A major disadvantage is that the switching problems generally are not discovered before the tap changer becomes entirely unusable. Often the whole transformer has to be switched off in an emergency manner as a consequence of inadequate tap changing, which implies considerable inconveniences for the consumers as well as extremely high expenses for the power industry.

Inspection of a tap changer generally requires opening of the enclosure and removal of the switching mechanism from the oil. This causes a lengthy service interruption and is hence performed as seldom as possible. Thus, solving the error detection problem by tap changer inspections on a regular basis is not a desirable option.

It is known in the prior art to measure acoustic signals in tap changers to obtain information about the functional qualities thereof. According to US 5,492,014 acoustic signals resulting from, among other things, tap-changing operations are measured. The "sound" of the operations is recorded and unusual sounds are used as indications of unusual events. Such acoustic measurements require specially adapted equipment and are often associated with problems due to resonance, spurious signals, disturbances, etc.
Moreover, diagrams resulting from acoustic measurements are generally very difficult to interpret, in particular since every system has its own acoustic characteristics. Such system is described in WO 00/44011 A, where a vibro-acoustic signal emitted by a high-voltage switching system, for example a tap-changer, and creating a signature, which are compared with a reference signature to indicate failures during the switching operation.

Patent Abstracts of Japan of JP 1-95505 describes a system to improve the reliability of abnormality detection in an on-load tap changer, comprising a pressure detector detecting the oil pressure. The system does not give any indication of type of failure during switching operation.

Accordingly, there is a strong demand for a method and means, which facilitates early detection of switching problems in a tap changer.

### SUMMARY

A general object of the present invention is to improve diagnosing and error detection in tap changers. A specific object is to provide a diagnosing method as defined in the claim 1, and means as defined in the claim 9, for early detection of switching-related problems in a tap changer.

These objects are achieved in accordance with the attached claims.

The present invention is based on the recognition that information about switching operations in a tap changer can be obtained from pressure monitoring of the tap changer insulating liquid. A diagnosing method is provided comprising registering pressure in an insulating liquid of a tap changer as a function of time for a period of time in which a switching action of the tap changer is carried through, and extracting switching-related information from the registered pressure diagram. The method is preferably used for a single-phase tap changer and comprises the step of relating quantities derived from the measured pressure peaks to specific arcings of the switching action. In this way, early error detection is achieved, whereby transformer failures can be avoided. Repeated measurements at different loads are preferably performed, followed by trend evaluation. If a trend indicating tap changer problems is detected, an alarm signal is triggered to call for a pre-scheduled tap changer inspection. The method according to the invention may further comprise switching off the transformer if the pressure exceeds a pre-determined value as well as extracting information of the base pressure in the tap changer and relating it to the level of insulating liquid. These features are very advantageous, since they replace conventional pressure guards and oil level sensors.

### BRIEF DESCRIPTION OF THE DRAWINGS

The invention, together with further objects and advantages thereof, may best be understood by making reference to the following description taken together with the accompanying drawings, in which:
- Fig. 1: is a schematic illustration of a transformer with a tap changer system which may be used with the present invention;
- Fig. 2: is a schematic view of an on-load tap changer which may be used with the present invention;
- Fig. 3A-3F: are circuit diagrams illustrating a switching sequence in the tap changer of Fig. 2;
- Fig. 4: is an exemplary diagram of pressure versus time obtained in accordance with the present invention;
- Fig. 5: illustrates a measurement set-up in accordance with the present invention; and
- Fig. 6: is a flow diagram of a method of tap changer diagnosing in accordance with the present invention.

### DETAILED DESCRIPTION

Throughout the drawings the same reference numbers are used for similar or corresponding objects.

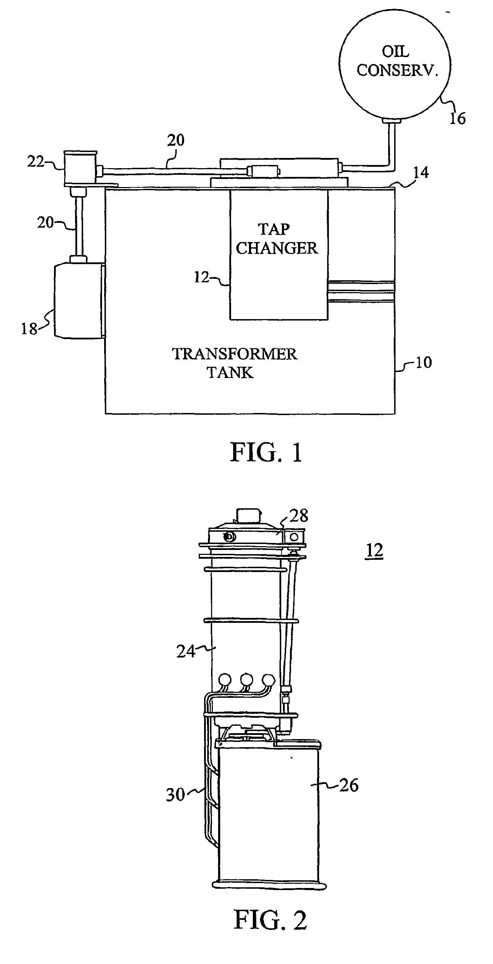

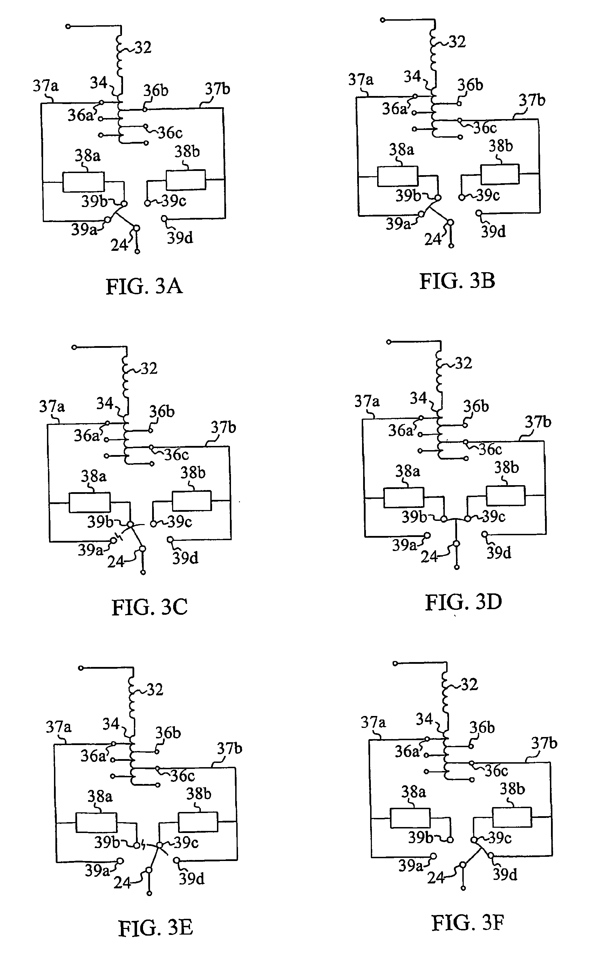

Fig. 1 is a schematic illustration of a transformer with a tap changer system which may be used with the present invention. A transformer tank 10 comprising a tap changer 12 is shown. The illustrated tap changer 12 is suspended from a transformer cover 14, but other tap changers 12 may be arranged outside the transformer tank 10. Both the transformer tank 10 and the tap changer 12 are filled with an insulating liquid, preferably oil, stored in an oil conservator 16. To avoid contamination of transformer oil, e.g. from arcing which will be described with reference to Fig. 3, the tap changer 12 has a tight housing separating its insulating liquid from the transformer insulating liquid. Power to operate the tap changer 12 is supplied from a motor-drive mechanism 18, which is mounted on the outside of the transformer tank 10. The power is transmitted by means of shafts 20 and bevel gears 22.

Fig. 2 is a schematic view of an on-load tap changer, which may be used with the present invention. The illustrated tap changer 12 is of an *"UC type* and detailed information thereof can be found in our technical guide "On-*load tap changers, type UC"* (available on the internet). The tap changer 12 is formed of two main parts, a diverter switch 24 and a tap selector 26, interrelated by connections 30. A conventional top housing 28 of the diverter switch 24 comprises a three-way valve onto which, besides connection flanges and connections for test equipment, a pressure guard (not shown) is mounted. The pressure guard trips a main circuit breaker of the transformer if a certain pressure level is exceeded. Thus, the complete transformer is switched off in the event of over-pressure and high oil flow rates in the conservator (16 in Fig. 1).

Basically, the tap selector 26 selects the desired tap upon initiation of a tap change. The diverter switch 24 then transfers the current from the tap in service to the selected tap. While this quick changeover is occurring, a resistance is connected into the circuit to ensure that there is no break in transfer of current. This also limits the circulating current between the two taps of the winding during the switching operation.

A switching sequence in the tap changer of Fig. 2 will now be described with reference to the circuit diagrams of Fig. 3A-3F. The circuit includes an untapped winding 32, a tapped winding 34 with taps 36a, 36b, 36c, tap selector contacts 37a, 37b, transition resistors 38a, 38b and the diverter switch 24 with main contacts 39a, 39d and transition contacts 39b, 39c. A duplicate circuit is provided in order to make one circuit carry the load current, while switching is carried out by the other. In Fig. 3A, the main contact 39a of the diverter switch 24 is closed, whereby the load current is allowed to bypass the resistor 38a and is carried directly to the selector contact 37a and tap 36a of the tapped winding 34. The selector contact 37b lies on a first tap 36b in the part of the circuit presently carrying no current (to the right in Fig. 3A). Still in a non-current state, selector contact 37b switches to a selected second tap 36c, resulting in Fig. 3B. Thereafter, the diverter switch 24 rotates clockwise making the main contact 39a break in such way that the current now flows via the transition contact 39b and the transition resistor 38a (Fig. 3C). The breaking occurs in the first current zero after contact separation.

In the next step of the switching sequence, illustrated in Fig. 3D, the diverter switch 24 has continued to rotate clockwise. The transition contact 39c of the previously non-conducting circuit part is closed whereafter the load current is divided into two branches and a circulating current flows in the circuit between the taps 36a and 36c. The circulating current is limited by the two transition resistors 38a, 38b avoiding short-circuiting. When the transition contact 39b in the next stage (Fig. 3E) breaks, the entire load current flows via the transition resistor 38b from the selected tap 36c.

Finally, in Fig. 3F, the switching sequence and thus the tap changing is completed with bypassing of the resistor 38b by connection of the main contact 39d and a full load current to tap 36c is obtained. The number of windings in the transformer and hence the voltage output level has been altered. A complete tap changing sequence of the described type typically lasts about 50 ms.

The present invention is not limited to the described tap changer circuit. Other embodiments may for instance use change-over selectors to achieve a reduced number of turns in the windings as compared to the described linear switching. Moreover, the number of resistors may vary and the resistors may be replaced by other impedances. The illustrated flag cycle operation may also be replaced by pennant cycle operation.

In the described embodiment there are thus two contact breaks in the diverter switch 24 during the described switching sequence, leading to the situations of Fig. 3C and 3E, respectively. As the contacts break, the high voltage give rise to arcing indicated by flash-symbols in Fig. 3C and 3E. In a successful switching operation, the life of an arc is completed within one half-cycle (max 10 ms at 50 Hz). The arcing causes thermal degradation of the insulating liquid, resulting in formation of volumes filled with gas. One consequence of this is that the gas formation in turn leads to sudden pressure changes in the insulating liquid. Since the insulating liquid has a limited compressibility and the casing is rigid, the pressure increase is distributed within the liquid and can be measured at almost any position. Another consequence of the thermal degradation is that the insulating liquid is contaminated.

The present invention is based on the recognition that information about switching operations in a tap changer can be obtained from pressure monitoring of the tap changer insulating liquid. As will be described in detail in the following, it has unexpectedly shown that pressure diagrams present a time resolution enough to identify different arcs and are therefore highly suitable as basis for extraction of switching-related information.

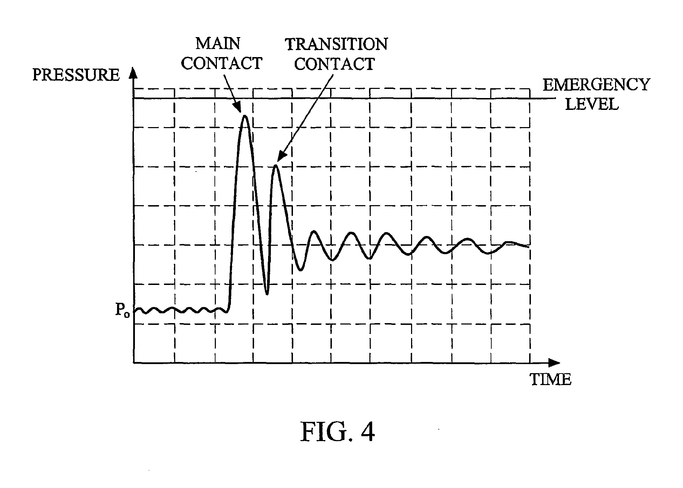

Fig. 4 is an exemplary diagram of pressure versus time obtained in accordance with the present invention. Pressure was measured in the insulating liquid of a single-phase tap changer for a period of time well exceeding the tap changer switching time. The two arcs of the switching sequence (compare Fig. 3C and 3E) give rise to two very distinct pressure peaks. The first pressure peak originates from the arc caused by breaking the main breaking contact, while the second peak is related to breaking of the transition contact. After the second arcing, and the associated pressure peak, the pressure in the tap changer fluctuates with lower amplitude and the mean pressure slowly decreases until the base pressure Po is regained. (Fig. 4 does not cover a time period long enough for this to be fully visible.)

Since the pressure peaks indisputably can be related to a respective arcing, features of the peaks, such as height, width and separation time, provides information of the arcing and thereby of the switch condition in the tap changer. Exemplary conclusions drawn from pressure diagrams of the type disclosed in Fig. 4 will now be given.

The intensity, i.e. a height or area measure, of a pressure peak is mainly related to the arc power. A high pressure peak implies fast formation of relatively large gas bubbles. This is due to a high electrical current and/or a relatively long arcing time. However, the arcing time may not exceed one half-cycle to manifest itself as a high pressure peak. If the arcing time, on the other hand, does exceed half a period, a relighted arc may be present, e.g. due to minor switching problems or overload. Since this leads to a relatively long duration of gas formation, it can be identified as a wide pressure peak. Thus, the width of a pressure peak generally provides information of the duration of the corresponding arc.

Evaluation of the separation in time of two pressure peaks, e.g. one from a main contact and one from a transition contact, provides very useful information about the tap changer switching speed. A relatively long period of time between the peaks indicates a low switching speed, or in other words a poor breaking ability. This could even result in a relighted arc implying wide peaks. Furthermore, the time between arcs correspond to well defined specifications of the tap changer switches. By comparing the time in the pressure diagram with the specifications, a deviation may be detected. Such a deviation indicates severe switching problems in the tap changer.

Finally, information about the status of the tap changer may also be retained from the time until the pressure reaches the base pressure Po following a switching sequence. A very long such decay time could be caused by a non-working connection to the expansion tank. Generally, this would also manifest itself as larger amplitudes of the oscillations following the transition contact peak.

It should be noted that the above-described diagnosing and error detection situations are merely given as examples. Of course, other switching-related information may as well be interpreted from a pressure diagram according to the present invention. Furthermore, the invention covers tap changer systems with different numbers of contact breaks, i.e. different arcing situations leading to other diagram characteristics. Embodiments with pennant cycle operation would for example disclose a different number of arcs and consequently a different number of peaks in the pressure diagram.

Preferably, diagnosing based on pressure monitoring according to the present invention is used for single-phase tap changers. Single-phase tap changers imply pressure diagrams similar to Fig. 4, in which the pressure peaks are clearly distinguishable and from which switching information hence is easy to extract. If the same measurement was performed for a multi-phase tap changer, where each phase implies a similar switching sequence as in Fig. 3, there would be two additional pressure peaks for each additional phase and a time delay between the pairs of peaks. The result could be overlapping pressure peaks, making the diagram interpretation somewhat more complicated. The invention covers tap changers of any number of phases, i.e. triple or other multiple-phase systems as well as single-phase tap changers. Nevertheless, it is evident that a single-phase tap changer is a system where the present invention is easiest to implement. Most favourable is to use the invention for tap changer systems with rigid devices and casings, since the peaks in the pressure diagram then become very sharp.

The pressure monitoring and diagram evaluation according to the present invention is preferably performed continuously or repeated at suitable time intervals. Then, pressure peaks formed at different loads on the tap changer system are registered. In this way, identification of trends related to switching features is possible. One embodiment of the invention comprises triggering of an alarm signal if e.g. an increasing or decreasing trend in the height or width of the pressure peaks is detected. The alarm signal implies that a pre-scheduled inspection of the tap changer should be performed whenever suitable.

The major benefit of the present invention is that it enables early detection of switching related errors. In the above-described way, incipient problems related to the tap changing function may be identified before they cause major damages. This implies that the occurrence of transformer failures decreases, which in turn is very advantageous for economical as well as environmental reasons.

There are additional advantages associated with embodiments of the invention. Firstly, the pressure monitoring according to the invention may be used to trigger the pressure guard, i.e. to switch off the transformer when a pre-determined emergency pressure value is exceeded. The pressure diagram can be useful in order to determine whether the tap changer pressure really is increasing in a long-term point-of-view or if the pressure merely has risen instantaneously following a comparatively strong arcing. As a result, transformer failures due to "false" pressure alarms may be avoided, reducing the expenses of the power industry. Secondly, the base pressure of the pressure diagrams obtained in accordance with the present invention may be extracted and converted to the level of insulating liquid (generally oil) in the tap changer. In this way, no separate oil level sensor is needed in the tap changer.

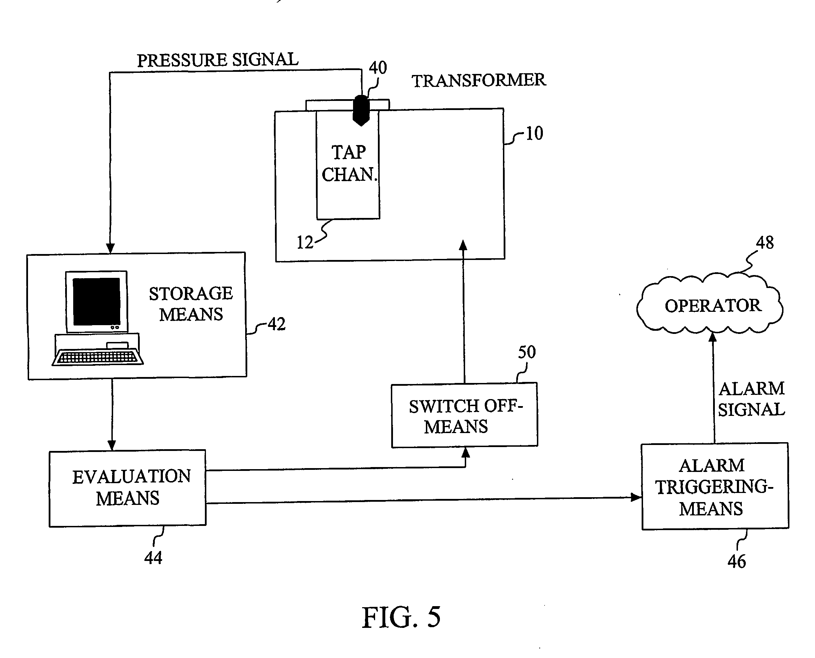

Fig. 5 illustrates a measurement set-up in accordance with the present invention. The transformer tank 10, into which the tap changer 12 is suspended, is shown. A pressure sensor 40 measures the pressure of the insulating liquid in the tap changer 12. Preferably, a very fast pressure sensor 40 is used in order to properly register changes in the insulating liquid pressure during a tap changing sequence. For the measurements resulting in the diagram of Fig. 4 a pressure sensor of type DPI 260 available from Druck Ltd, with a response of 2 kHz, was used. The pressure sensor 40 is in a preferred embodiment of the invention arranged in the top housing (28 in Fig. 2) of the diverter switch. Existing connections may then be employed and a simple solution for pressure sensor implementation is achieved. This constitutes yet another advantage of the present invention.

The pressure signal is transferred from the pressure sensor 40 to means 42 for signal storing. From there, evaluation means 44 may collect data for diagnosing and evaluation for instance according to the above-described principles. When a trend is detected, the evaluation means 44 makes alarm-triggering means 46 release an alarm signal notifying an operator 48 of the need for tap changer inspection. Such an inspection typically involves both the transformer and the tap changer 12. The evaluation means also communicates with means 50 for switching off the transformer. For the case of (non-false) over-pressure, the switch off-means 50 turns off the transformer. The actual hardware of the described means 42, 44, 46, 50 is conventional as such and will not be described further herein, since it is not in itself constituting a part of the present invention. However, the use thereof in this particular arrangement is new.

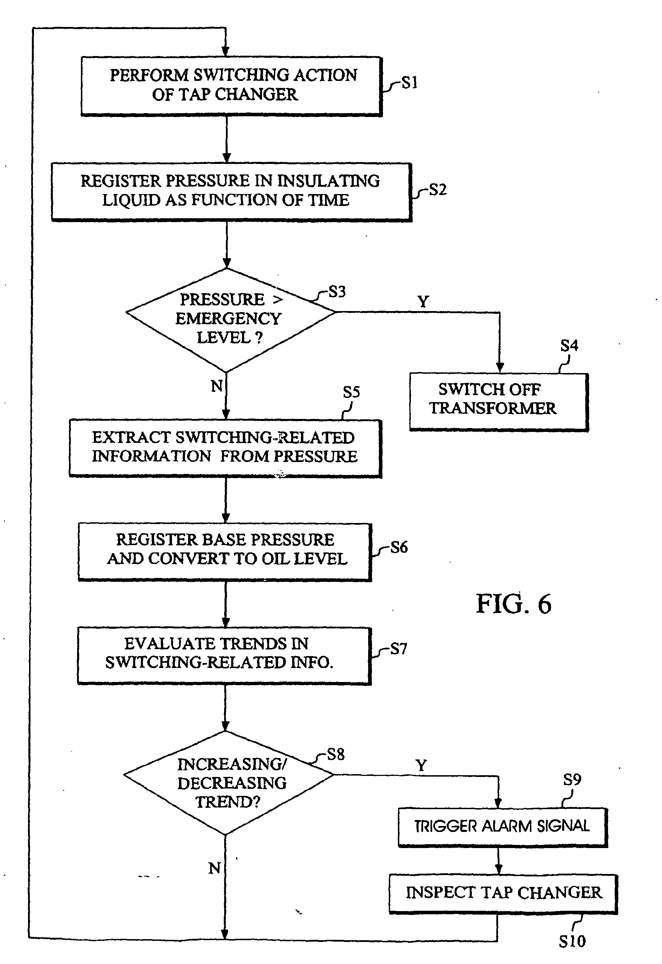

Fig. 6 is a flow diagram of a method of tap changer diagnosing in accordance with the present invention. In step S1, a switching action of a tap changer is performed. The pressure in the insulating liquid of the tap changer is registered as a function of time in step S2. In step S3, it is examined whether the tap changer pressure exceeds a pre-determined emergency level and preferably controlled that the change is not caused by known normal switching operations. If so is the case, the over-pressure results in switching off the transformer in step S4. If no over-pressure is at hand, pressure diagrams can be used to extract switching-related information in step S5. Furthermore, the base pressure may be registered and converted to level of insulating liquid in step S6. Preferably, the pressure measuring is repeated for a time period covering numerous switching actions at different loads on the tap changer. When several pressure diagrams have been recorded, trends in switching-related information can be evaluated in step S7. Step S8 checks whether there is an increasing or decreasing trend in switching-related information. Of course this involves determining how large a deviation has to be to imply a significant trend. If there is a significant trend, an alarm signal is triggered in step S9, whereafter the tap changer preferably is inspected in step S10. Otherwise, the diagnosing method steps are repeated beginning with the switching action in the step S1.

The method according to the present invention may be implemented by means of software, hardware, or a combination thereof. A computer program product implementing the method or a part thereof comprises a software or a computer program run on a general purpose or specially adapted computer, processor or microprocessor. The software includes computer program code elements or software code portions that make the computer perform the method using at least one of the steps previously described in Fig. 6. The program may be stored in whole or part, on, or in, one or more suitable computer readable media or data storage means such as a magnetic disk, CD-ROM or DVD disk, hard disk, magneto-optical memory storage means, in RAM or volatile memory, in ROM or flash memory, as firmware, or on a data server.

Although the invention has been described herein with reference to specific illustrated embodiments thereof, it should be emphasized that the invention also covers modifications and variants thereof that are obvious to the man skilled in the art. Therefore, the scope of the invention should only be limited by the enclosed claims.

## Claims

1. Diagnosing method of a tap changer (12) having an insulating liquid comprising the steps of
performing a switching action of said tap changer (12); and
registering pressure in said insulating liquid as a function of time for a period of time comprising the time in which said switching action is carried through, **characterized by** the further step of
extracting switching-related information from said registered pressure function, said extracting step in turn comprising the steps of
identifying a first pressure peak in said registered pressure function;
relating quantities from said first pressure peak to a first arcing of said switching action;
relating said first arcing to breaking a main contact of a diverter switch (24) in said tap changer (12) during said switching action; and
identifying a second pressure peak in said registered pressure function;
relating quantities from said second pressure peak to a second arcing of said switching action;
relating said second arcing to breaking a transition contact of said diverter switch (24) in said tap changer (12) during said switching action; and
diagnosing a switching condition associated with said main and said transition contact, the switching condition being an error condition when the quantities from said first and/or second pressure peak or the first and/or second arcing are outside a predetermined interval.

2. The method according to claim 1, **characterized in that** said extracting step further comprises the step of
relating the time separation between said first and second pressure peaks to switching speed.

3. The method according to any of preceding claims 1-2, **characterized in that** said extracting step further comprises the step of
relating a width of said first and/or second pressure peak to arc duration.

4. The method according to any of preceding claims, **characterized in that** said extracting step further comprises the step of
relating an intensity measure of said first and/or second pressure peak to arc power.

5. The method according to any of preceding claims, **characterized in that** said switching operation is carried out on a single-phase tap changer.

6. The method according to any of preceding claims, **characterized by** the further steps of
extracting information of a base pressure in said tap changer (12); and converting said base pressure to a level of insulating liquid in said tap changer (12) .

7. The method according to any of preceding claims, **characterized in that** said registering step is repeated, and by the further step of
evaluating trends in said switching-related information,
triggering an alarm signal if an increasing or decreasing trend in said switching-related information is detected.

8. The method according to any of preceding claims, **characterized in** registration of pressure in said insulating liquid comprising oil.

9. Diagnosing means for a tap changer (12) having an insulating liquid and comprising
means (40) for registering pressure in said insulating liquid as a function of time for a period of time comprising the time in which a switching action of said tap changer is carried through, **characterized by**
means (44) for extracting switching-related information from said registered pressure function comprising
means for identifying a first pressure peak in said registered pressure function;
means for relating quantities from said first pressure peak to a first arcing of said switching action;
means for relating said first arcing to breaking a main contact of a diverter switch (24) in said tap changer (12) during said switching action; and
means for identifying a second pressure peak in said registered pressure function;
means for relating quantities from said second pressure peak to a second arcing of said switching action;
means for relating said second arcing to breaking a transition contact of a diverter switch (24) in said tap changer (12) during said switching action; and
means for diagnosing a switching condition associated with said main contact and transition contact,
the switching condition being an error condition when quantities from said first and/or second pressure peak or the first and/or second arcing are outside a predetermined interval.

10. The means according to claim 9, **characterized in that** it is adapted for a single-phase tap changer.

11. The means according to claim 9 or 10, **characterized by**
means for repeating said registering step,
means (42) for storing said registered pressure functions, and
means (44) for evaluating trends in said switching-related information.

12. The means according to claim 11, **characterized by**
means (46) for triggering an alarm signal if an increasing or decreasing trend in said switching-related information is detected.

## Patentansprüche

1. Diagnoseverfahren eines Stufenschalters (12), der eine isolierende Flüssigkeit aufweist, wobei das Verfahren die Schritte umfasst:
Ausführen einer Schaltaktion des Stufenschalters (12); und
Erfassen des Drucks in der isolierenden Flüssigkeit als Funktion der Zeit für eine Zeitperiode, die die Zeit umfasst, in welcher die Schaltaktion ausgeführt wird, charakterisiert durch den weiteren Schritt:
Extrahieren von schaltbezogener Information aus der erfassten Druckfunktion, wobei der Extrahierschritt wiederum die Schritte umfasst:
Identifizieren einer ersten Druckspitze in der erfassten Druckfunktion;
Größen aus der ersten Druckspitze zu einer ersten Bogenbildung der Schaltaktion in Beziehung Setzen,
die erste Bogenbildung zum Unterbrechen eines Hauptkontakts eines Umstellschalters (24) in dem Stufenschalter (12) während der Schaltaktion in Beziehung Setzen; und
Identifizieren einer zweiten Druckspitze in der erfassten Druckfunktion;
Größen aus der zweiten Druckspitze zu einer zweiten Bogenbildung der Schaltaktion in Beziehung Setzen,
die zweite Bogenbildung zum Unterbrechen eines Übergangskontakts des Umstellschalters (24) in dem Stufenschalter (12) während der Schaltaktion in Beziehung Setzen; und
Diagnostizieren eines mit dem Haupt- und Übergangskontakt assoziierten Schaltzustands, wobei der Schaltzustand ein Fehlerzustand ist, wenn die Größen aus der ersten und/oder zweiten Druckspitze oder die erste und/oder zweite Bogenbildung außerhalb eines vorbestimmten Intervalls liegen.

2. Das Verfahren nach Anspruch 1, **dadurch gekennzeichnet, dass** der Extrahierschritt weiter den Schritt umfasst:
den Zeitabstand zwischen der ersten und der zweiten Druckspitze zu einer Schaltgeschwindigkeit in Beziehung Setzen.

3. Das Verfahren nach einem der Ansprüche 1-2, **dadurch gekennzeichnet, dass** der Extrahierschritt weiter den Schritt umfasst:
eine Breite der ersten und/oder zweiten Druckspitze zu einer Bogendauer in Beziehung Setzen.

4. Das Verfahren nach einem der vorhergehenden Ansprüche, **dadurch gekennzeichnet, dass** der Extrahierschritt weiter den Schritt umfasst:
ein Intensitätsmaß der ersten und/oder zweiten Druckspitze zu einer Bogenleistung in Beziehung Setzen.

5. Das Verfahren nach einem der vorhergehenden Ansprüche, **dadurch gekennzeichnet, dass** die Schaltoperation auf einem Einphasenstufenschalter ausgeführt wird.

6. Das Verfahren nach einem der vorhergehenden Ansprüche, durch die weiteren Schritte **gekennzeichnet**:
Extrahieren von Information über einen Basisdruck in dem Stufenschalter (12); und Konvertieren des Basisdrucks auf ein Niveau der isolierenden Flüssigkeit in dem Stufenschalter (12).

7. Das Verfahren nach einem der vorhergehenden Ansprüche, **dadurch gekennzeichnet, dass** der Erfassungsschritt wiederholt wird, und **gekennzeichnet durch** den weiteren Schritt:
Auswerten von Trends in der schaltbezogenen Information,
Auslösen eines Alarmsignals, wenn ein zunehmender oder abnehmender Trend in der schaltbezogenen Information detektiert wird.

8. Das Verfahren nach einem der vorhergehenden Ansprüche, **gekennzeichnet durch** Erfassung von Druck in der isolierenden Flüssigkeit, die Öl umfasst.

9. Diagnosemittel für einen Stufenschalters (12), der eine isolierende Flüssigkeit aufweist, umfassend:
Mittel (40) zum Erfassen des Drucks in der isolierenden Flüssigkeit als Funktion der Zeit für eine Zeitperiode, die die Zeit umfasst, in welcher eine Schaltaktion ausgeführt wird, charakterisiert durch:
Mittel (44) zum Extrahieren von schaltbezogener Information aus der erfassten Druckfunktion, umfassend:
Mittel zum Identifizieren einer ersten Druckspitze in der erfassten Druckfunktion;
Mittel, um Größen aus der ersten Druckspitze zu einer ersten Bogenbildung der Schaltaktion in Beziehung zu setzen,
Mittel, um die erste Bogenbildung zum Unterbrechen eines Hauptkontakts eines Umstellschalters (24) in dem Stufenschalter (12) während der Schaltaktion in Beziehung zu setzen; und
Mittel zum Identifizieren einer zweiten Druckspitze in der erfassten Druckfunktion; Mittel, um Größen aus der zweiten Druckspitze zu einer zweiten Bogenbildung der Schaltaktion in Beziehung zu setzen,
Mittel, um die zweite Bogenbildung zum Unterbrechen eines Übergangskontakts des Umstellschalters (24) in dem Stufenschalter (12) während der Schaltaktion in Beziehung zu setzen; und
Mittel zum Diagnostizieren eines mit dem Hauptkontakt und Übergangskontakt assoziierten Schaltzustands, wobei der Schaltzustand ein Fehlerzustand ist, wenn die Größen aus der ersten und/oder zweiten Druckspitze oder die erste und/oder zweite Bogenbildung außerhalb eines vorbestimmten Intervalls liegen.

10. Das Mittel gemäß Anspruch 9, **dadurch gekennzeichnet, dass** es für einen Einphasenstufenschalter eingerichtet ist.

11. Das Mittel gemäß Anspruch 9 oder 10, **gekennzeichnet durch**
Mittel zum Wiederholen des Erfassungsschrittes,
Mittel (42) zum Speichern der erfassten Druckfunktionen, und
Mittel (44) zum Auswerten von Trends in der schaltbezogenen Information.

12. Die Mittel nach Anspruch 11, **gekennzeichnet durch**
Mittel (46) zum Auslösen eines Alarmsignals, wenn ein zunehmender oder abnehmender Trend in der schaltbezogenen Information detektiert wird.

## Revendications

1. Procédé de diagnostic d'un changeur de prises (12) comportant un liquide isolant comprenant les étapes consistant à :
effectuer une action de commutation dudit changeur de prises (12) ; et
enregistrer la pression régnant dans ledit liquide isolant en fonction du temps pendant un intervalle de temps comprenant le temps pendant lequel ladite action de commutation est exécutée, **caractérisé par** l'étape supplémentaire consistant à :
extraire des informations liées à la commutation de ladite fonction de pression enregistrée, ladite étape d'extraction comprenant elle-même les étapes consistant à :
identifier un premier pic de pression dans ladite fonction de pression enregistrée ;
relier les quantités provenant dudit premier pic de pression à une première formation d'arc de ladite action de commutation ;
relier ladite première formation d'arc à la rupture d'un contact principal d'un commutateur (24) dans ledit changeur de prises (12) pendant ladite action de commutation ; et
identifier un deuxième pic de pression dans ladite fonction de pression enregistrée ;
relier les quantités provenant dudit deuxième pic de pression à une deuxième formation d'arc de ladite action de commutation ;
relier ladite deuxième formation d'arc à la rupture d'un contact de transition dudit commutateur (24) dans ledit changeur de prises (12) pendant ladite action de commutation ; et
diagnostiquer un état de commutation associé audit contact principal et audit contact de transition, l'état de commutation étant un état d'erreur quand les quantités provenant dudit premier et/ou dudit deuxième pic de pression ou ladite première et/ou deuxième formation d'arc sont en dehors d'un intervalle prédéterminé.

2. Procédé selon la revendication 1, **caractérisé en ce que** ladite étape d'extraction comprend en outre l'étape consistant à relier la séparation temporelle entre lesdits premier et deuxième pics de pression à la vitesse de commutation.

3. Procédé selon l'une quelconque des revendications 1 à 2, **caractérisé en ce que** ladite étape d'extraction comprend en outre l'étape consistant à relier une largeur dudit premier et/ou deuxième pic de pression à la durée d'arc.

4. Procédé selon l'une quelconque des revendications précédentes, **caractérisé en ce que** ladite étape d'extraction comprend en outre l'étape consistant à relier une mesure d'intensité dudit premier et/ou deuxième pic de pression à la puissance d'arc.

5. Procédé selon l'une quelconque des revendications précédentes, **caractérisé en ce que** ladite opération de commutation est effectuée sur un changeur de prises monophasé.

6. Procédé selon l'une quelconque des revendications précédentes, **caractérisé par** les étapes supplémentaires consistant à extraire une information d'une pression de base dans ledit changeur de prises (12), et convertir ladite pression de base en un niveau de liquide isolant dans ledit changeur de prises (12).

7. Procédé selon l'une quelconque des revendications précédentes, **caractérisé en ce que** ladite étape d'enregistrement est répétée, et par les étapes supplémentaires consistant à :
évaluer les tendances dans ladite information liée à la commutation,
déclencher un signal d'alarme si une tendance croissante ou décroissante dans ladite information liée à la commutation est détectée.

8. Procédé selon l'une quelconque des revendications précédentes, **caractérisé par** l'enregistrement de la pression dans ledit liquide isolant comprenant de l'huile.

9. Moyen de diagnostic pour changeur de prises (12) comportant un liquide isolant et comprenant :
un moyen (40) pour enregistrer la pression régnant dans ledit liquide isolant en fonction du temps pendant un intervalle de temps comprenant le temps pendant lequel une action de commutation dudit changeur de prises est exécutée, **caractérisé par** :
un moyen (44) pour extraire des informations liées à la commutation de ladite fonction de pression enregistrée comprenant :
un moyen pour identifier un premier pic de pression dans ladite fonction de pression enregistrée ;
un moyen pour relier les quantités provenant dudit premier pic de pression à une première formation d'arc de ladite action de commutation ;
un moyen pour relier ladite première formation d'arc à la rupture d'un contact principal d'un commutateur (24) dans ledit changeur de prises (12) pendant ladite action de commutation ; et
un moyen pour identifier un deuxième pic de pression dans ladite fonction de pression enregistrée ;
un moyen pour relier les quantités provenant dudit deuxième pic de pression à une deuxième formation d'arc de ladite action de commutation ;
un moyen pour relier ladite deuxième formation d'arc à la rupture d'un contact de transition d'un commutateur (24) dans ledit changeur de prises (12) pendant ladite action de commutation ; et
un moyen pour diagnostiquer un état de commutation associé audit contact principal et audit contact de transition, l'état de commutation étant un état d'erreur quand les quantités provenant dudit premier et/ou dudit deuxième pic de pression ou la première et/ou deuxième formation d'arc sont en dehors d'un intervalle prédéterminé.

10. Moyen selon la revendication 9, **caractérisé en ce qu'**il est adapté pour un changeur de prises monophasé.

11. Moyen selon la revendication 9 ou 10, **caractérisé par** :
un moyen pour répéter ladite étape d'enregistrement,
un moyen (42) pour mémoriser lesdites fonctions de pression enregistrées, et
un moyen (44) pour évaluer les tendances dans ladite information liée à la commutation

12. Moyen selon la revendication 11, **caractérisé par** un moyen (46) pour déclencher un signal d'alarme si une tendance croissante ou décroissante dans ladite information liée à la commutation est détectée.
